(19) Europäisches Patentamt

European Patent Office

Office européen des brevets

(11) **EP 1 286 223 B1**

(12) **EUROPEAN PATENT SPECIFICATION**

(45) Date of publication and mention
of the grant of the patent:
**08.03.2006  Bulletin 2006/10**

(51) Int Cl.:
***G03F 7/20*** (2006.01)

(21) Application number: **02255876.1**

(22) Date of filing: **22.08.2002**

(54) **Method of measuring the aberration of a lithographic projection system**

Verfahren zur Messung der Aberration eines lithographischen Projektionssystems

Méthode de mesure de l'aberration d'un système de projection lithographique

(84) Designated Contracting States:
**DE FR GB IT NL**

(30) Priority: **23.08.2001  EP 01203188**

(43) Date of publication of application:
**26.02.2003  Bulletin 2003/09**

(73) Proprietor: **ASML Netherlands B.V.**
**5504 DR Veldhoven (NL)**

(72) Inventor: **van der Laan, Hans**
**5501 CL  Veldhoven (NL)**

(74) Representative: **Leeming, John Gerard**
**J.A. Kemp & Co.,**
**14 South Square,**
**Gray's Inn**
**London WC1R 5JJ (GB)**

(56) References cited:
**EP-A- 1 063 570**          **US-A- 5 424 552**
**US-A- 6 118 535**

**Description**

The present invention relates to a method of determining aberration of a projection system of a lithographic apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate; the method comprising the steps of:

- patterning the projection beam with said patterning means according to a test pattern;
- performing a real-time, direct determination of at least one parameter of an aerial image of the test pattern, formed by the projection system; and
- calculating at least one coefficient, representative of aberration of said projection system, on the basis of said at least one parameter.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from United States Patents US 5,296,891 and US 5,523,193. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such examples should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system also includes components operating according to any of these design types, and such components may also be referred to below, collectively or singularly, as a "lens". The radiation system as well as the projection system generally comprise components for directing, shaping or controlling the projection beam of radiation. In particular, the projection system will generally comprise means to set the numerical aperture (commonly referred to as the "NA") of the projection system, and the radiation system typically comprises adjusting means for setting the outer and/or inner radial extent (commonly referred to as σ-outer and σ-inner, respectively) of the intensity distribution upstream of the patterning means (in a pupil of the radiation system). Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791.

Generally, in order to realize integration of an increasing number of electronic components in an IC, it is necessary to increase the surface area of an IC and/or to decrease the size of the components. For the projection system, this means in particular that the resolution must be increased, so that increasingly smaller details, or line widths, can be imaged in a well-defined way onto a target portion. This requires a projection system that must comply with very stringent quality requirements. For example, due to manufacturing tolerances and generic lens design limitations, the projection system may exhibit residual aberration. In practice, the projection system is not an ideal (diffraction-limited) system; generally the projection system is an aberration-limited system. The influence of residual aberration becomes increasingly significant with the application of newer techniques, such as phase-shift masks or off-axis illumination, to enhance the resolving power of a lithographic projection apparatus. Said residual aberration may comprise low-order aberrations (such as, for example, third-order distortion, third-order x astigmatism, third-order 45° astigmatism, third-order x coma, third-order y coma and third order spherical aberration) as well as higher-order aberrations (such as, for example, fifth-order and seventh-order distortion, x and 45° astigmatism, x and y coma, and x and y three-wave aberration). For more information about aberrations mentioned above see, for example, the paper entitled "Towards a comprehensive control of full-field image quality in optical photolithography", authored by D. Flagello et al., *Proc. SPIE* **3051**, pp. 672-685, 1997.

Due to, for example, changing environmental conditions, or reversible changes as caused by lens heating, or ageing of components of the projection system as caused by interaction of the radiation of the projection beam with the material of said components, the low -and higher-order aberrations are not constant in time. In order to minimise the residual aberration (e.g. intermittently during a manufacturing process) modern projection lithography apparatus generally comprise means to measure low-order and/or higher-order aberrations contributing to said residual aberration, means to adjust said aberrations (e.g. through adjustments of the position of one or more movable lens elements of the projection system, or of the support structure), and means to calculate and apply the required adjustments. For a description of a method to substantially minimize said residual aberration see, for example, European Patent Application 01303036.6, published as EP 1 246 014 A1 and belonging to the prior art according to Article 54(3) EPC.

International Patent Application WO 00/31592 discloses methodology for the determination of aberration in an optical projection system. In particular, the said WO application describes the Aberration Ring Test ("ART"). This technique employs a series of ring-like features on a special test reticle, which are imaged through an optical projection system onto a photosensitive substrate. The images of the ring-like features on the substrate are then inspected, using a technique such as SEM (scanning electron microscopy). A comparison of the measured images with the corresponding original features on the reticle reveals the type(s) of aberration that the optical projection system has introduced into the images. The said WO application also describes a refinement of the ART technique known as ARTEMIS (ART Extended to Multiple Illumination Settings). This refinement makes use of the fact that each kind of aberration can be mathematically expressed as a specific Fourier harmonic that is a combination of a number of so-called Zernike polynomials, each with an associated Zernike aberration coefficient and weighting factor. In order to determine a number N of such Zernike aberration coefficients, the ART technique is performed at a plurality N of different groups of settings of σ-outer, σ-inner and NA. For simplicity, a group of settings of σ-outer, σ-inner and NA will be referred to hereinafter as a σ-NA setting. In this way, one is able to measure the same Fourier harmonic for each of the plurality N of σ-NA settings. Using a simulation program, reference values can be obtained for the above-mentioned weighting factors. In combination, this allows the desired set of Zernike aberration coefficients to be calculated, thus allowing quantification of the aberration concerned.

An alternative method to measure aberrations of a lithographic projection system is described in European Patent Application 01301571.4, published as EP 1 128 217 A2 and belonging to the prior art according to Article 54(3) EPC. It concerns an in situ measurement of aberrations, fast enough such as to not substantially impair the number of substrates that can be processed per unit of time. According to this method the projection beam is patterned into a desired test pattern, and the intensity distribution of the projected aerial image of the test pattern is detected, in situ, using detection means incorporated in the substrate table. The position of best-focus (along the optical axis of the projection system) as well as the lateral position (in mutually orthogonal directions perpendicular to the optical axis of the projection system) of the projected aerial image of said test pattern are measured for a plurality of different σ-NA settings. Coefficients, representative of one or more aberrations of the projection system can be calculated based on the results of said best focus and lateral position measurements. The method is referred to hereinafter by TAMIS (Transmission image sensing At Multiple Illumination Settings). Said test pattern is typically a segment of a periodic grating comprising lines and spaces, respectively substantially blocking and transmitting projection beam radiation, for example. Also, segments of such gratings wherein the width of said spaces is large compared to the width of said lines are used as test pattern. Typically, two test patterns with said lines and spaces arranged parallel to two corresponding, mutually orthogonal, directions (in the plane comprising the pattern) are used in order to enable measurement of aberrations such as, for example, x coma and y coma. However, in spite of such measures, the intensity distribution of projected aerial images of any such grating segments may not yield substantially detectable information on the presence of specific higher-order aberrations such as, for example, three-wave aberration. Consequently, there is the problem of providing test patterns suitable for reliably indicating and measuring the presence and magnitude of both low-order and higher-order aberrations, where the measurement can be done in situ such as to not substantially impair the number of substrates that can be processed per unit of time.

It is an object of the present invention to alleviate above mentioned problems. In particular, it is an object of the invention to provide a method of measuring aberration with improved sensitivity.

According to the invention, there is provided a method of determining aberration of an optical projection system as defined in the appended claims.

Here, the verb "contrast" refers to having a patterning effect on radiation of the projection beam. For example, contrasting isolated areas may be embodied as opaque or reflecting chromium areas on a surface of a substantially transparent reticle, or as substantially transmissive areas in a radiation blocking or reflecting chromium coating covering a reticle surface. Also, in analogy with attenuated phase shift masks, the transmittance and/or the phase shifting properties of isolated areas may differ from the transmittance and/or the phase shifting property of an area comprising said isolated areas, for example.

A pattern representative of an individual layer of a device may typically comprise a repeating two-dimensional structure of features positioned in accordance with a fictitious two-dimensional lattice in a plane comprising the pattern. The invention is based on the experience that the fidelity of a projected (aerial) image of such a pattern generally strongly depends on the presence of specific higher-order aberrations. Consequently, according to the invention a test pattern featuring a repeating two-dimensional structure of isolated areas positioned in accordance with said two-dimensional lattice is particularly suited for measurement of said specific higher-order aberrations.

Preferably, a test pattern featuring isolated areas positioned in accordance with a lattice, wherein said unit cell of said lattice is a hexagonal cell comprising six isolated areas positioned at or near the six corners of the hexagonal cell, is to be used for obtaining good sensitivity to (higher-order) three-wave aberration.

Generally, in order to obtain a desired sensitivity to specific, different types of higher-order aberrations, said unit cell of said lattice may have a shape selected from the group of shapes comprising triangular shape, quadrangular shape and hexagonal shape. Said isolated areas are not necessarily located at the corners of a unit cell. They may also be located along the sides of a unit cell, or both at the corners and along the sides of a unit cell, or within a unit cell.

The measurement of aberrations may be based on performing a real-time, direct determination of at least one parameter of an aerial image formed by the projection system, for a plurality of different settings of at least one system selected from the group of systems comprising said radiation system and said projection system (for example, a plurality of different σ-NA settings). The at least one parameter represents a difference between a property of a projected image of at least two isolated areas within one unit cell. Said property may be a property selected from the group of properties comprising peak intensity, spatially integrated intensity, spatial intensity distribution, the shape of an image cross section and the size of an image cross section, for example. The availability of a parameter representing said difference enables measurement of a larger number of aberration coefficients when compared with TAMIS, for example, in combination with the use of grating segments as test patterns.

In a particular embodiment of the invention, said real-time, direct determination of at least one parameter of an aerial image of the test pattern is performed with radiation detection means comprising a transmissivity-patterned radiation aperture, said transmissivity-patterned radiation aperture comprising a two-dimensional lattice of isolated areas with a transmissivity substantially different from the transmissivity of an area of said radiation aperture comprising said isolated areas. The positions of isolated areas of the detection aperture with respect to each other can be matched to positions of isolated areas of said test pattern, taking into account the magnification factor M of the projection system. The use of such a detection aperture for scanning a projected image of said test pattern and measuring aberrations may result in enhanced sensitivity in comparison with the use of a slit-shaped detection aperture.

Preferably, a plurality of parameters are determined at a corresponding plurality of different numerical aperture settings of the projection system and/or different settings of pupil filling at a pupil plane in the radiation system. These different settings of pupil filling can comprise different illumination modes selected from the group comprising disc-shaped, annular, quadrupolar, dipolar and soft-multipolar illumination mode, for example. For more information on the definition and realization of illumination modes, see for example United States Patent Application 09/287,014 published as US 2001/046038 A1, not belonging to the prior art according to Article 54 EPC, and corresponding to EP 0 949 541 A2, which belongs to the prior art according to Article 54(2) EPC.

Alternatively said at least one parameter may be the position of best focus and/or the lateral position of a projected image of the test pattern.

The invention may also provide the step of calculating a theoretical variation, for each of said plurality of different settings, of the or each parameter as a function of a small change in said at least one coefficient, representative of aberration of the projection system. Subsequently, one can calculate said at least one coefficient by multiple regression or a least-square fit of a set of simultaneous equations. In particular, Zernike aberration coefficients can be obtained.

In a further embodiment of the invention, there is provided, besides said test pattern featuring isolated areas positioned in accordance with a lattice, at least one supplementary test pattern for measuring aberrations, such as for example x astigmatism and 45° astigmatism. Said supplementary test pattern may be selected, for example, from the group of two-dimensional structures comprising a segment of a grating with periodic lines and spaces, and a repeating structure of parallel, line-shaped isolated areas.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- using a projection system to project the patterned beam of radiation onto a target portion of the layer of radiation-sensitive material;
- prior to the step of using the projection system, determining aberration of said projection system by a method according to the claims; and

correcting for said aberration on the basis of said at least one calculated coefficient, to reduce aberration of an image projected by said projection system.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm).

Embodiments of the invention will now be described, by way of example only, with reference to the accompanying schematic drawings in which:

Figure 1 depicts a lithographic projection apparatus according to an embodiment of the invention;
Figure 2 depicts a so-called "brick wall" pattern and a corresponding lattice with hexagonal unit cells.

Figure 3 depicts a test pattern of isolated areas, corresponding to a lattice of hexagonal unit cells.

Figure 4 illustrates an intensity distribution of a projected image of a test pattern of isolated areas, corresponding to a lattice of hexagonal unit cells (as illustrated in Figure 3), in the absence of residual aberration. A plot of a local intensity distribution is shown; along the vertical axis is the intensity of the projection beam radiation as a function of position along a line in the x-direction, traversing a lattice point.

Figure 5 illustrates an intensity distribution of a projected image of a test pattern in the presence of three-wave aberration. The graph shows, along the vertical axis, a detected signal as measured with a slit-shaped radiation detector, and along the horizontal axis a lateral position of said slit-shaped radiation detector.

Figure 6 shows a decomposition of the detected signal into a harmonic signal and a first higher order harmonic signal. Along the vertical axis the signals are plotted, and along the horizontal axis a lateral position of the slit-shaped radiation detector is plotted.

Figure 7 lists a table of Zernike coefficients and polynomials.

Figure 8 illustrates a correlation between measurement results for aberrations as measured with ARTEMIS, with a shearing interferometer, and with the present method. Along the vertical axis, a root mean square value in nm of a difference between measurement results is plotted.

Figure 9 shows a test pattern with isolated areas positioned on a lattice featuring a quadrangular unit cell.

Embodiment 1

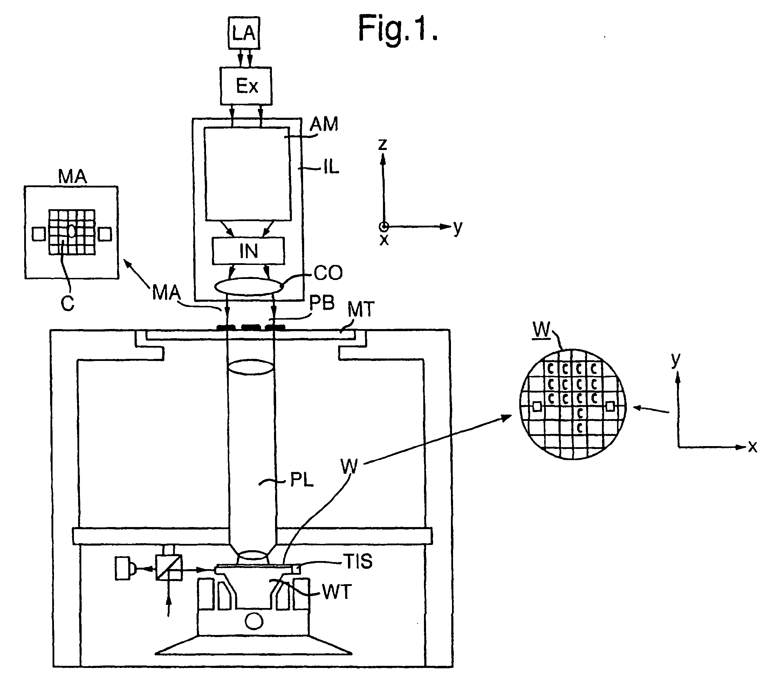

Figure 1 schematically depicts a lithographic projection apparatus according to a particular embodiment of the invention. The apparatus comprises:

a radiation system Ex, IL, for supplying a projection beam PB of radiation (*e.g.* UV radiation, or radiation with wavelengths within spectral wavelength ranges substantially centered at 248 nm, 193 nm, 157 nm, 126 nm or 13.5 nm). In this particular case, the radiation system also comprises a radiation source LA;

a first object table (mask table) MT provided with a mask holder for holding a mask MA (*e.g.* a reticle), and connected to first positioning means for accurately positioning the mask with respect to item PL;

a second object table (substrate table) WT provided with a substrate holder for holding a substrate W (*e.g.* a resist-coated silicon wafer), and connected to second positioning means for accurately positioning the substrate with respect to item PL;

a projection system ("lens") PL (*e.g.* a quartz and/or $CaF_2$ lens system, a catadioptric system comprising lens elements made from such materials, or a mirror system) for imaging an irradiated portion of the mask MA onto a target portion C (*e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* a UV excimer laser, a laser-produced plasma source, a discharge source, or an undulator or wiggler provided around the path of an electron beam in a storage ring or synchrotron) produces a beam of radiation. This beam is fed into an illumination system (illuminator) IL, either directly or after having traversed conditioning means, such as a beam expander Ex, for example. The illuminator IL comprises adjusting means AM for setting σ-outer and σ-inner, respectively, of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

In scan mode, essentially the same scenario applies, except that a given target portion C is not exposed in a single "flash". Instead, the mask table MT is movable in a given direction (the so-called "scan direction", *e.g.* the y direction) with a speed $v$, so that the projection beam PB is caused to scan over a mask image; concurrently, the substrate table WT is simultaneously moved in the same or opposite direction at a speed $V = Mv$, in which $M$ is the magnification of the lens PL (typically, $M$ = 1/4 or 1/5). In this manner, a relatively large target portion C can be exposed, without having to compromise on resolution.

To enable a measurement of aberrations a particular mask comprises test patterns. Generally, standard alignment marks, consisting of equal lines/spaces (e.g. with a line width of 8 $\mu$m for the imaged mark) along the x- and y-directions in Figure 1, and special, asymmetrically segmented alignment markers are used as test patterns. The lateral position (i.e. the position in the x,y plane shown in Figure 1, also referred to as the horizontal position hereinafter) and best focus position (i.e. the position along the z direction in Figure 1, also referred to as the vertical position hereinafter) of aerial images of test patterns can be measured with a transmission image sensor TIS. The transmission image sensor TIS is inset into a physical reference surface associated with the substrate table WT. In a particular embodiment, two sensors are mounted on a fiducial plate mounted to the top surface of the substrate table WT, at diagonally opposite positions outside the area covered by the wafer W. The fiducial plate is made of a highly stable material with a very low coefficient of thermal expansion, e.g. Invar, and has a flat reflective upper surface that may carry markers used with another fiducial in alignment processes. The transmission image sensor TIS is used to determine directly the vertical and horizontal position of the aerial image, as projected by the projection lens, of a test pattern on the mask. It comprises apertures in the reflective surface close behind which is placed a photodetector sensitive to the radiation used for the exposure process. In particular it may comprise slit-shaped apertures with slits parallel to the x and/or y direction in Figure 1. In general, a specific test pattern is used in combination with a specific, corresponding aperture of the transmission image sensor TIS. To determine the position of the focal plane, the projection lens projects into space an image of a test pattern provided on the mask MA and having contrasting light and dark regions. The substrate stage is then scanned horizontally (in one or preferably two directions) and vertically so that a corresponding aperture of the transmission image sensor TIS passes through the space where the aerial image is expected to be. As said corresponding aperture passes through the light and dark portions of the image of the test pattern, the output of the photodetector will fluctuate (a Moiré effect). The vertical level at which the rate of change of amplitude of the photodetector output is highest indicates the level at which the image of a test pattern has the greatest contrast and hence indicates the plane of optimum focus. The horizontal position at which the rate of change is highest indicates the aerial image's lateral position. An example of a transmission image sensor of this type is described in greater detail in US 4,540,277. Advantages of the transmission image sensor include robustness and speed because it is a direct measurement technique not involving exposure of a resist.

In the embodiment of this invention a test pattern suitable for measuring low-order aberrations and higher-order aberrations (such as three-wave aberration) is considered. The presence of three-wave aberration is particularly detrimental for the fidelity of a projected image of a pattern with so called "brick wall" structure. In a brick wall structure a rectangular shaped isolated area is arrayed like bricks in a brick wall. Consequently, according to the invention a test pattern featuring a repeating, two-dimensional structure in accordance with a brickwall geometry can be used for improving the accuracy of a measurement of this specific higher-order aberration.

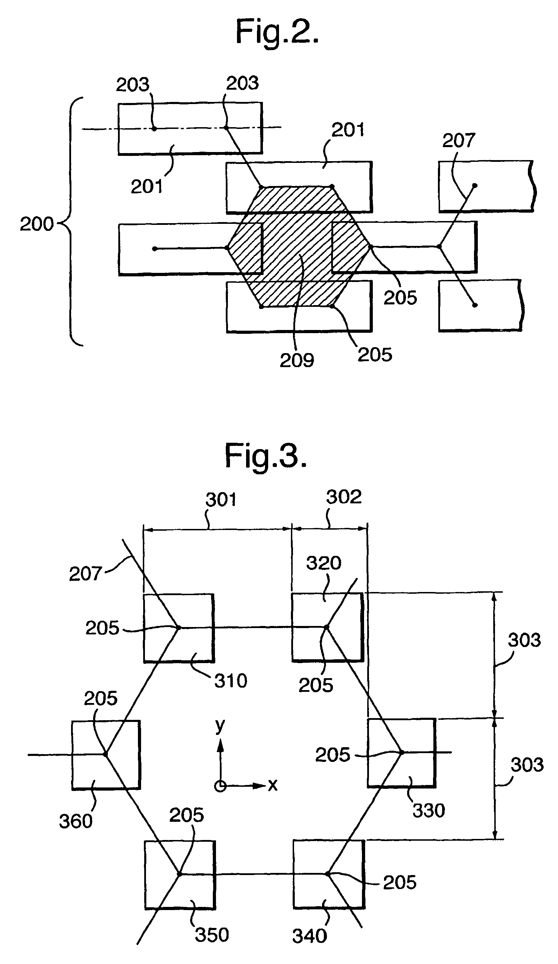

In Figure 2 the characteristic structure of a (two-dimensional) brick wall 200 is illustrated. The position of each elongated rectangular-shaped isolated area representing a (two-dimensional) brick 201 can be defined by the position of two points 203, each point located on the long axis of symmetry of a brick 201 and at a fixed distance from a corresponding end face of said brick 201. The points 203 of the bricks 201 coincide with the lattice points 205 of a lattice 207. The lattice 207 is characterised by a hexagonal unit cell 209. Such a lattice is referred to as a honeycomb lattice or a HC-lattice, hereinafter, and a test pattern with isolated areas positioned at or near the lattice points 205 will be referred to as a honeycomb pattern or a HC-pattern.

In Figure 3 a typical layout of a unit cell of a HC-pattern is shown. The isolated areas 310, 320, 330, 340, 350 and 360 of the unit cell of the HC-pattern are substantially centered at points 205 of a hexagonal lattice 207. In the case of a mask the HC-pattern can be embodied as, for example, substantially transmissive square areas surrounded by a radiation blocking layer (such as for example a chrome layer) on a surface of a reticle. The separations 301, 302, and 303 are, for example, in a preferred embodiment 400 nm, 200 nm, and 350 nm respectively.

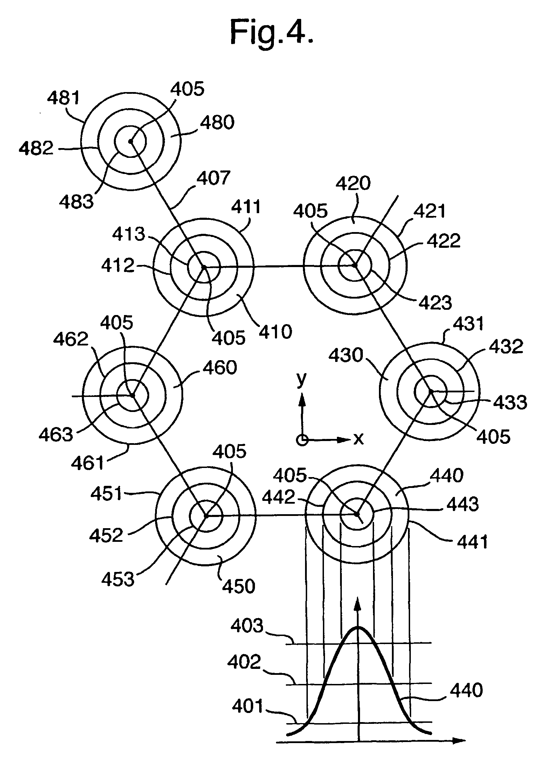

A projected image of such a HC-pattern is shown schematically in Figure 4 for a unit cell and one isolated area of a neighbouring unit cell. In the image the presence of isolated areas 310, 320, 330, 340, 350 and 360 of a unit cell of the HC-pattern is apparent through corresponding intensity distributions 410, 420, 430, 440, 450 and 460 at or near the points 405 of a corresponding hexagonal lattice 407. The intensity distribution 480 in Figure 4 is an image of a corresponding isolated area of a neighbouring unit cell in the test pattern; other such intensity distributions are (for simplicity) not shown in Figure 4. To distinguish the intensity distribution of an image of the HC-pattern as a whole from an intensity distribution of an image of a single isolated area, such as for example the intensity distribution 440, the latter intensity distributions may be referred to as "local" intensity distributions hereinafter. In Figure 4 a plot of a local intensity distribution is shown for the intensity distribution 440. Plotted along the vertical axis is the intensity of the projection beam radiation as a function of position along a line in the x-direction, traversing the lattice point 405 comprised by the intensity distribution 440. The set of intensity contour lines 441, 442, and 443 in Figure 4 represent lines of equal local intensity, respectively intensities 401, 402 and 403. These intensities are similarly represented by the sets of intensity contour lines (411, 412, 413), (421, 422, 423), (431, 432, 433), (451, 452, 453), (461, 462, 463) and (481, 482, 483) characterizing the local intensity distributions 410, 420, 430, 450, 460, and 480 respectively.

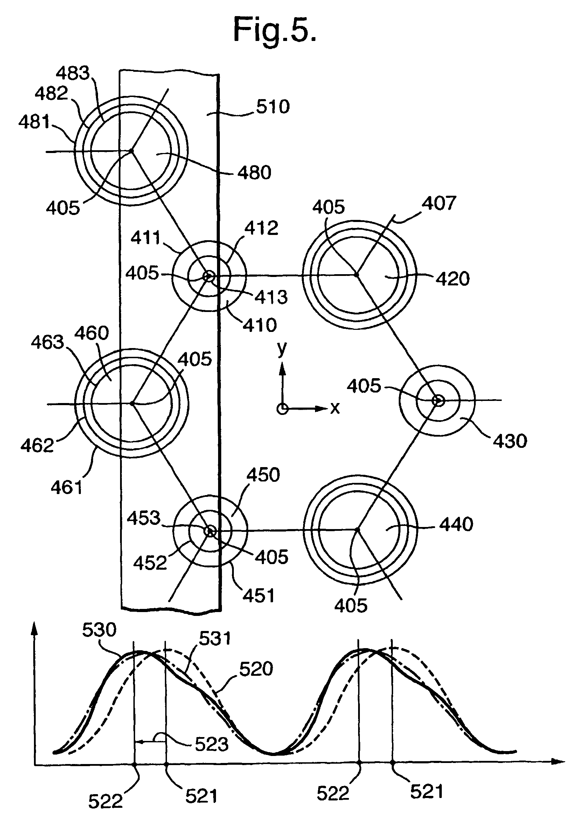

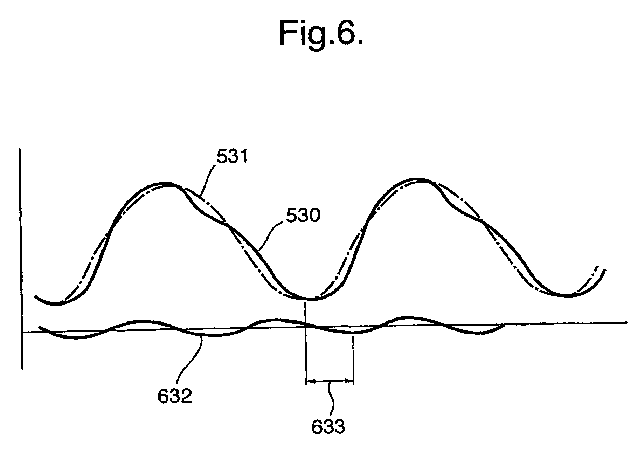

In the absence of aberrations said properties of an image of an isolated area (such as for example the peak intensity of local intensity distributions) are substantially equal; this situation is shown in Figure 4. Generally, in the presence of residual aberration, said properties of images of isolated areas are mutually different. For example, in the presence of x three-wave aberration, the peak intensity of the intensity distributions 410, 430 and 450 differs from the peak intensity of the intensity distributions 420, 440, 460 and 480. In Figure 5 this effect is illustrated; the intensity contour lines 461, 462, 463 and 481, 482, 483 of the local intensity distributions 460 and 480 respectively, for example, are displaced radially outwards from the corresponding lattice points 405 with respect to their positions in Figure 4, indicative of an increase of peak intensity. Similarly, the contour lines 411, 412, 413 and 451, 452, 453 of the local intensity distributions 410 and 450, respectively, are displaced radially inwards, indicative of a decrease of peak intensity. This effect can be measured by scanning (in the x direction in Figure 5) the intensity distribution of the image of the test pattern with a slit-shaped aperture 510 of the TIS (with the slit parallel to the y axis in Figure 5). The graph in Figure 5 shows, along the vertical axis, the detected intensity by the TIS, as a function of position of the slit along the x direction. In the absence of residual aberration, the detected intensity 520 is a periodically varying function of x with peak values occurring at slit x-positions 521; the presence of x three-wave aberration leads to a (phase) shifted periodically varying intensity signal 530 with peak values occurring at slit x-positions 522. A measurable parameter of the image of the test pattern (representative of x three-wave aberration) is, for example, the position shift indicated by the arrow 523 in Figure 5. The present embodiment is, however, not limited to this parameter. For example, from the detected signal 530 a best-fit sinusoidally varying function 531 can be determined, and the phase shift between the signals 520 and 531 can be measured. Alternatively, as is illustrated in Figure 6, the detected signal 530 can be decomposed into said best-fit sinusoidally varying function 531 and a first higher-order harmonic signal 632. The phase shift 633 of the signal 632 is a measurable parameter representative of x three-wave aberration.

Preferably Zernike aberration coefficients, also referred to as Zernike coefficients, are measured. These coefficients, representative of said aberrations of said projection system, describe in particular the projection lens wavefront aberrations. The wavefront aberration W can be written as a series called a Zernike expansion according to the angular form:

$$W = Zif_i(r,\theta) + Zjf_j(r,\theta) + Zkf_k(r,\theta) + \dots \tag{1}$$

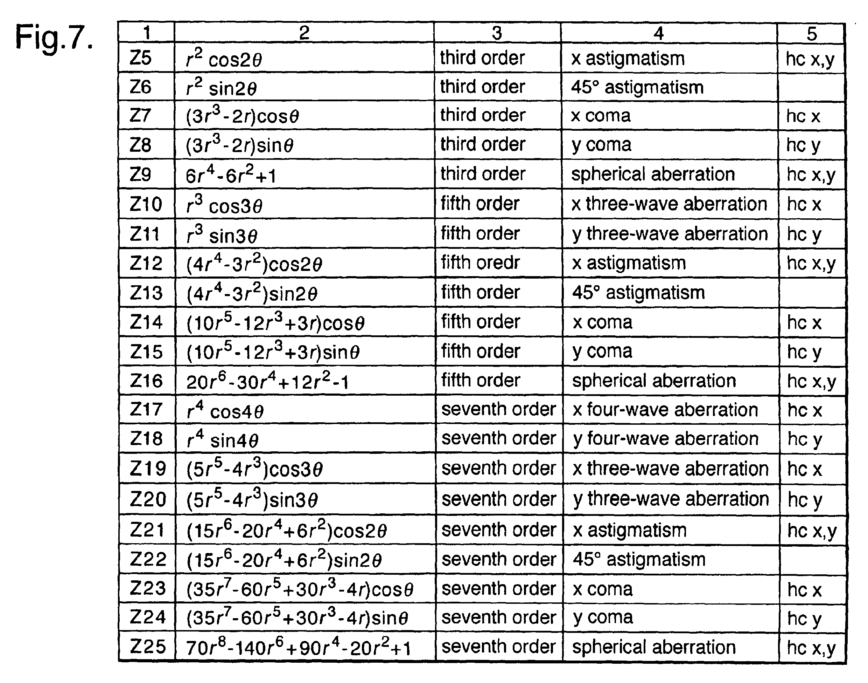

where each Z is a Zernike coefficient and each $f$ is the corresponding Zernike polynomial, and where $r$ and $\theta$ are radial and angular co-ordinates, respectively. Here, $r$ is normalized by the radius of the pupil of the projection system. The functions $f$ take the form of the product of a polynomial in $r$ and in sin or cos of $m\theta$. The table shown in Figure 7 lists, in column 1, the Zernike coefficient, in column 2 the corresponding Zernike polynomial, in column 3 the so called "order" of the aberration, and in column 4 a name of the aberration. Column 5 is used for reference below.

According to the TAMIS method, parameters which can be used to measure Zernike aberration coefficients include: the position of best focus, and the lateral position of the image of the test pattern as a whole. As explained above, the parameters relating to differences between local intensity distributions, for example those mentioned above, can be used as well. Any of the parameters is preferably measured for a plurality of different σ-NA settings. The relation between measured parameters and Zernike aberration coefficients can be expressed in the following way:

$$Pmeas = \overline{\overline{Scalc}}Z \tag{2}$$

Here, the components of the vector *Pmeas* may be any of the parameters as measured, at any of preferred σ-NA settings. Further, the components of the vector Z are the Zernike aberration coefficients which are to be measured, and the elements of the matrix $\overline{\overline{Scalc}}$ are calculated sensitivity coefficients which, in linear approximation, relate the value of a Zernike aberration to the value of a parameter, as measured. With a HC-pattern as partly shown in Fig 3, the vector Z may, for example, contain the Zernike aberration coefficients marked "hc x" in the Table shown in Figure 7. A supplementary HC-pattern, rotated 90 degrees in the x,y plane of Figure 3, can be used to measure the Zernilce aberrations marked "hc y" in the Table shown in Figure 7. The Zernike aberration coefficients can be calculated from the measured data by inverting Equation (2). When the use of two mutually orthogonal HC-patterns is needed to calculate a single aberration coefficient from the measurement data, this is indicated by "hc x,y" in column 5 of the Table shown in Figure 7.

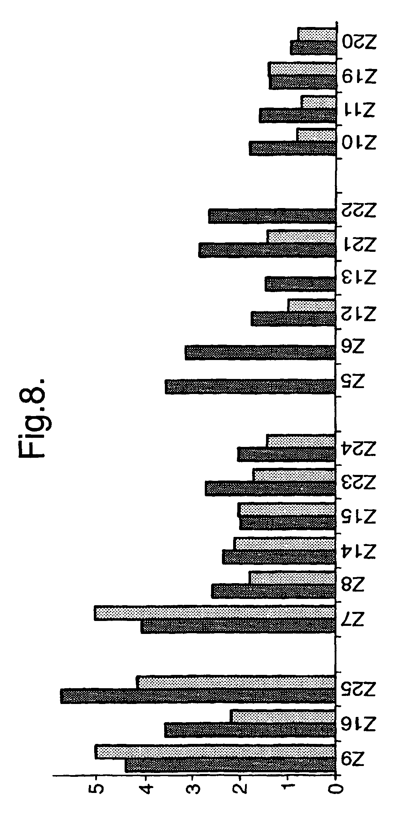

Confirmation of the usefulness of the technique of the present invention is illustrated in Figure 8. For a specific projection system of a lithographic projection apparatus operated at a wavelength of 248 nm, and featuring a maximum NA of 0.75, the values of Zernike coefficients were measured by the lens manufacturer at a set of 13 different positions along the x direction in an image field (corresponding to a target portion C), using a technique referred to hereafter as SIF (a through-the-lens Shearing InterFerometry method developed by the manufacturer). The measurement results obtained with SIF are used for reference, and compared with Zernike aberrations as measured according to ARTEMIS and according to the current method. As a result, for each of the latter two methods, 13 difference values corresponding to the set of said 13 different positions are obtained for each Zernike coefficient. In Figure 8 the root mean square values of said 13 difference values are plotted along the vertical axis, in nm, for a number of different Zernike aberration coefficients. The solid black bars represent the results obtained with ARTEMIS; the shaded bars represent the results obtained with the method disclosed here, using a HC-pattern, which will be referred to as HC-TAMIS hereafter. Figure 8 shows that the correlation of the HC-TAMIS measurement results with the SIF measurement results is comparable with or even better than the correlation of the ARTEMIS measurement results with the SIF measurement results. The improvement over ARTEMIS is in particular substantial for the measurement of the x three-wave and y three-wave aberration coefficients Z10 and Z11, respectively.

Embodiment 2

The invention is not limited to the use of HC-pattems. In a second embodiment, which may be the same as the first embodiment save as described below, a test pattern comprising a two-dimensional lattice of isolated areas, where the unit cell has a quadrangular shape, is used. Such a test pattern is sensitive, for example, to the presence of x and y four-wave aberration.

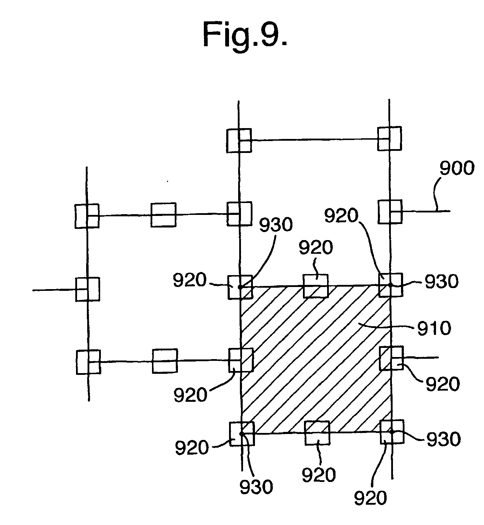

A test pattern characterized by a lattice of arrayed quadrangular unit cells may have isolated areas at or near the corners of the lattice, but is not limited to such a lay out. In Figure 9, an example of a test pattern matched to a lattice 900 featuring a quadrangular unit cell 910 with eight isolated areas 920 (four of which are located at or near the corners 930 of a unit cell) is shown. The use of such a test pattern leads to enhanced sensitivity to both three -and four-wave aberration.

Generally, test patterns with triangular, quadrangular and hexagonal shaped unit cells can be used, depending on the desired sensitivity to specific aberrations. Alternatively, for measuring x and y coma, and x and 45° astigmatism, for example, test patterns comprising a segment of a grating with periodic lines and spaces, and/or a repeating structure of parallel, line-shaped isolated areas can be used. Preferably, a test pattern for measuring aberrations comprises a plurality of different, constituent test patterns such as mentioned here, for example.

Embodiment 3

In a third embodiment, which may be the same as the first or second embodiment save as described below, the image sensor TIS comprises a radiation aperture featuring a two-dimensional lattice of isolated, substantially transmissive areas in the reflective upper surface of the fiducial plate. This way, the sensitivity of the detected signal to the presence of aberrations can be enhanced compared to the sensitivity as obtained using a slit-shaped aperture.

For example, in combination with a HC-pattern for use as test pattern, a detection aperture comprising a hexagonal array of isolated apertures (referred to hereinafter, for simplicity, as "sub-apertures") can be used. The shape of the sub-apertures is not a critical parameter; the shape of the sub-apertures may, for example, be circular or rectangular. The positions of said sub-apertures with respect to each other, in said reflective upper surface of the fiducial plate, are matched to positions of isolated areas of said HC-pattern, taking into account the magnification factor M of the projection system. This way, a match with positions of images of isolated areas of the HC-test pattern can be obtained when the test pattern is in alignment with the detection aperture. The area of the detection aperture comprising said sub-apertures may, for example, be slit-shaped, as described in embodiment 1. Scanning a projected image of the HC-pattern with such a slit-shaped detection aperture comprising said sub-apertures leads to an enhanced modulation of the detected signal as a function of scan position of the detection aperture, and to an enhancement of the effect on the detected signal of the presence of aberrations, such as indicated in the graphs 530 in Figure 5.

Alternatively, two separate radiation apertures, each comprising sub-apertures positioned in accordance with a two-dimensional lattice, and each radiation aperture providing radiation to a corresponding, separate radiation detector, can be used. For example, the sub-apertures of one radiation aperture can be positioned in accordance with a lattice featuring a triangular unit cell, such that - in alignment, as described above - a match with the positions of the intensity distributions 410, 430 and 450 in Figure 4 occurs. Similarly, the sub-apertures of the other radiation aperture can be embodied such as to match - in alignment - with the positions of the intensity distributions 420, 440 and 460 in Figure 4. Such a dual aperture lay out provides enhanced sensitivity to aberration induced lateral displacements of the intensity distributions 410, 430 and 450 with respect to the intensity distributions 420, 440 and 460 in Figure 4.

The present embodiment is not limited to the example of the HC-pattern and the scheme of matching sub-apertures to desired, specific isolated areas of a hexagonal unit cell of the test pattern. In a similar way, one or more radiation detection apertures comprising sub-apertures can be embodied for use with test patterns in accordance with lattices featuring triangular and quadrangular unit cells. Also, any desired scheme of matching sub-apertures to desired, specific isolated areas of a unit cell of a test pattern can be embodied as described in the example above.

Whilst specific embodiments of the invention have been described above, it will be appreciated that the invention may be practised otherwise than as described. The description is not intended to limit the invention, which is defined by the claims.

**Claims**

1. A method of determining aberration of a projection system of a lithographic apparatus comprising:

   - a radiation system (IL) for supplying a projection beam of radiation;
   - a support structure (MT) for supporting patterning means (MA), the patterning means serving to pattern the projection beam according to a desired pattern;
   - a substrate table (WT) for holding a substrate; and
   - a projection system (PL) for projecting the patterned beam onto a target portion of the substrate; the method comprising the steps of:

      - patterning the projection beam with said patterning means according to a test pattern (200);
      - performing a real-time, direct determination of at least one parameter of an aerial image of the test pattern, formed by the projection system; and
      - calculating at least one coefficient, representative of aberration of said projection system, on the basis of said at least one parameter;

   wherein said test pattern (200) comprises a two-dimensional lattice (207) of isolated areas that contrast with an area of said test pattern comprising said isolated areas, and the unit cell (209) of said lattice comprises at least three of said isolated areas; **characterised in that** said parameter (523, 633) represents a difference between the images (450, 460) of two of the isolated areas (350, 360) within one unit cell.

2. A method according to claim 1, wherein said unit cell (209) of said lattice is a hexagonal cell comprising six isolated areas (310-360) positioned at or near the six corners of the hexagonal cell.

3. A method according to claim 1, wherein said unit cell (209) of said lattice (207) has a shape selected from the group of shapes comprising triangular shape, quadrangular shape and hexagonal shape.

4. A method according to claim 1, wherein said difference is a difference in a property selected from the group of properties consisting of peak intensity, spatially integrated intensity, spatial intensity distribution, the shape of an image cross section and the size of an image cross section.

5. A method according to any of the claims 1-4, wherein said at least two of the isolated areas within one unit cell are neighboring areas (350, 360) within one unit cell.

**6.** A method according to any one of claims 1 to 5 wherein said real-time, direct determination is performed with radiation detection means comprising a plurality of radiation apertures, arrayed in a two-dimensional matrix pattern.

**7.** A method according to any one of claims 1 to 6 wherein said realtime, direct determination is performed for a plurality of different settings of at least one system selected from the group of systems consisting of said radiation system (IL) and said projection system (PL).

**8.** A method according to claim 7, wherein said plurality of different settings comprise different numerical aperture settings.

**9.** A method according to claim 7 or 8, wherein said plurality of different settings comprise different settings of the outer and/or inner radial extent of the intensity distribution at a pupil plane in the radiation system.

**10.** A method according to claim 7, 8 or 9, wherein said plurality of different settings comprise different illumination modes selected from the group comprising disc-shaped, annular, quadrupolar, dipolar and soft-multipolar illumination mode.

**11.** A method according to any one of the preceding claims, wherein said at least one parameter is the position of best focus and/or the lateral position of said image of the test pattern.

**12.** A method according to any one of the preceding claims, further comprising the step of calculating a theoretical variation, for each of said plurality of different settings, of the or each determined parameter as a function of a change in said at least one coefficient.

**13.** A method according to any one of the preceding claims, wherein said at least one coefficient is calculated by multiple regression or a least-square fit of a set of simultaneous equations.

**14.** A method according to any one of the preceding claims, wherein said at least one coefficient is a Zernike coefficient.

**15.** A method according to any one of the preceding claims, wherein said test pattern comprises at least one supplementary test pattern for determining aberrations.

**16.** A method according to claim 15, wherein said at least one supplementary test pattern is selected from the group of two-dimensional pattern structures comprising a segment of a grating with periodic lines and spaces, and a repeating structure of parallel, line-shaped isolated areas.

**17.** A method of manufacturing a device using a lithographic projection apparatus, comprising the steps of:

- providing a substrate (W) that is at least partially covered by a layer of radiation-sensitive material;
- providing a projection beam (PB) of radiation using a radiation system;
- using patterning means (MA) to endow the projection beam with a pattern in its cross-section;
- using a projection system (PL) to project the patterned beam of radiation onto a target portion of the layer of radiation-sensitive material; and

prior to the step of using the projection system, determining aberration of said projection system by a method according to any one of the preceding claims and correcting for said aberration on the basis of said at least one calculated coefficient, to reduce aberration of an image projected by said projection system.

**18.** A lithographic apparatus comprising:

- a radiation system (IL) for supplying a projection beam (PB) of radiation;
- a support structure (MT) for supporting patterning means, the patterning means (MA) serving to pattern the projection beam according to a desired pattern;
- a substrate table (WT) for holding a substrate (W); and
- a projection system (PL) for projecting the patterned beam into a target portion (C) of the substrate;

wherein said apparatus further comprises

- means arranged to perform a real-time direct determination of at least one parameter of an aerial image formed by the projection system (PL) of a test pattern (200) comprising a two-dimensional lattice (207) of isolated areas (310, 320, 330, 340, 350, 360), wherein the unit cell (209) of said lattice comprises at least three of said isolated areas; **characterised in that**:

said parameter (523, 633) represents a difference between the images (450, 460) of two of the isolated areas (350, 360) within one unit cell (209).

**Patentansprüche**

1. Ein Verfahren zur Bestimmung der Aberration eines Projektionssystems einer lithographischen Vorrichtung, mit:

- einem Bestrahlungssystem (IL) zur Zufuhr eines Projektionsstrahls einer Strahlung;
- einer Lagerstruktur (MT) zur Lagerung von Musterungsmitteln (MA), wobei die Musterungsmittel dazu dienen, den Projektionsstrahl gemäß einem gewünschten Muster zu mustern;
- einem Substrattisch (WT) zum Halten eines Substrats; und
- einem Projektionssystem (PL) zum Projizieren des gemusterten Strahls auf einen Zielabschnitt auf dem Substrat, wobei das Verfahren die Schritte aufweist von:

- Mustern des Projektionsstrahls mittels der Musterungsmittel gemäß einem Testmuster (200);
- Durchführen einer Direktbestimmung in Echtzeit wenigstens eines Parameters eines im Raum erzeugten Bildes des Testmusters, gebildet durch das Projektionssystem; und
- Berechnen wenigstens eines Koeffizienten, der die Aberration des Projektionssystems darstellt, auf der Grundlage des wenigstens einen Parameters,
- wobei das Testmuster (200) ein zweidimensionales Gitter (207) isolierter Bereiche aufweist, welche mit einem Bereich des Testmusters, welches die isolierten Bereiche aufweist, kontrastieren und wobei eine Einzelzelle (209) des Gitters wenigstens drei der isolierten Bereiche aufweist, **dadurch gekennzeichnet, dass** der Parameter (523, 633) eine Differenz zwischen den Bildern (450, 460) von zwei der isolierten Bereiche (350, 360) innerhalb einer Einzelzelle darstellt.

2. Ein Verfahren nach Anspruch 1, wobei die Einzelzelle (209) des Gitters eine sechseckförmige Zelle ist, welche sechs isolierte Bereiche (310-360) aufweist, die bei oder nahe den sechs Ecken der sechseckförmigen Zelle angeordnet sind.

3. Ein Verfahren nach Anspruch 1, wobei die Einzelzelle (209) des Gitters (209) eine Form hat, ausgewählt aus einer Gruppe von Formen enthaltend eine Dreiecksform, Quadratform und Sechseckform.

4. Ein Verfahren nach Anspruch 1, wobei die Differenz eine Differenz in einer Eigenschaft ist, die ausgewählt ist aus der Gruppe von Eigenschaften bestehend aus Spitzenintensität, räumlich integrierter Intensität, räumlicher Intensitätsverteilung, der Form eines Bildquerschnittes und der Größe eines Bildquerschnittes.

5. Ein Verfahren nach einem der Ansprüche 1 bis 4, wobei wenigstens zwei der isolierten Bereiche innerhalb einer Einzelzelle einander benachbarte Bereiche (350, 360) innerhalb einer Einzelzelle sind.

6. Ein Verfahren nach einem der Ansprüche 1 bis 5, wobei die direkte Bestimmung in Echtzeit mit Strahlungserkennungsmitteln durchgeführt wird, welche eine Mehrzahl von Strahlungsaperturen aufweisen, welche in einem zweidimensionalen Matrixmuster angeordnet sind.

7. Ein Verfahren nach einem Ansprüche 1 bis 6, wobei die direkte Bestimmung in Echtzeit für eine Mehrzahl von unterschiedlichen Einstellungen wenigstens eines Systems durchgeführt wird, ausgewählt aus der Gruppe von Systemen, bestehend aus dem Bestrahlungssystem (IL) und dem Projektionssystem (PL).

8. Ein Verfahren nach Anspruch 7, wobei die Mehrzahl von unterschiedlichen Einstellungen unterschiedliche numerische Apertureinstellungen aufweist.

9. Ein Verfahren nach Anspruch 7 oder 8, wobei die Mehrzahl von unterschiedlichen Einstellungen unterschiedliche Einstellungen des äußeren und/oder inneren radialen Betrags der Intensitätsverteilung in einer Pupillenebene in

**12**

dem Bestrahlungssystem aufweist.

10. Ein Verfahren nach Anspruch 7, 8 oder 9, wobei die Mehrzahl von unterschiedlichen Einstellungen unterschiedliche Beleuchtungsmoden aufweist, ausgewählt aus der Gruppe bestehend aus dem scheibenförmigen, ringförmigen, quadrupolen, dipolaren und weich-multipolaren Beleuchtungsmodus.

11. Ein Verfahren nach einem der vorhergehenden Ansprüche, wobei der wenigstens eine Parameter die Position des besten Fokus und/oder der zeitlichen Position des Bildes des Testmusters ist.

12. Ein Verfahren nach einem der vorhergehenden Ansprüche, weiterhin aufweisend den Schritt der Berechnung einer theoretischen Schwankung, für jede aus der Mehrzahl unterschiedlicher Einstellungen, des oder der bestimmten Parameter als eine Funktion einer Änderung in dem wenigstens einen Koeffizienten.

13. Ein Verfahren nach einem der vorhergehenden Ansprüche, wobei der wenigstens eine Koeffizient berechnet wird durch eine multiple Regression oder eine Methode der kleinsten Quadrate eines Satzes gleichzeitiger Gleichungen.

14. Ein Verfahren nach einem der vorhergehenden Ansprüche, wobei der wenigstens eine Koeffizient ein Zemike-Koeffizient ist.

15. Ein Verfahren nach einem der vorhergehenden Ansprüche, wobei das Testmuster wenigstens ein Zusatz-Testmuster zur Bestimmung von Aberrationen aufweist.

16. Ein Verfahren nach Anspruch 15, wobei das wenigstens eine Zusatz-Testmuster ausgewählt wird aus der Gruppe von zweidimensionalen Musterstrukturen, aufweisend ein Segment eines Gitters mit periodischen Linien und Abständen und einer sich wiederholenden Struktur von parallelen, linienförmigen isolierten Bereichen.

17. Ein Verfahren zur Herstellung einer Vorrichtung unter Verwendung einer lithographischen Projektionsvorrichtung, aufweisend die Schritte von:

    - Bereitstellen eines Substrats (W), welches wenigstens teilweise durch eine Schicht aus strahlungsempfindlichem Material bedeckt ist;
    - Bereitstellen eines Projektionsstrahls (PB) einer Strahlung unter Verwendung eines Bestrahlungssystems;
    - Verwenden einer Musterungsvorrichtung (MA), um den Projektionsstrahl in seinem Querschnitt mit einem Muster zu versehen;
    - Verwenden eines Projektionssystems (PL) zur Projektion des gemusterten Strahls der Strahlung auf einen Zielabschnitt der Schicht aus strahlungsempfindlichem Material; und
    - Bestimmung der Aberration des Projektionssystems durch ein Verfahren nach einem der vorhergehenden Ansprüche vor dem Schritt der Verwendung des Projektionssystems und

Korrigieren der Aberration auf der Grundlage des wenigstens einen berechneten Koeffizienten, um die Aberration eines durch das Projektionssystem projizierten Bildes zu verringern.

18. Eine lithographische Vorrichtung, aufweisend:

    - ein Bestrahlungssystem (IL) zur Lieferung eines Projektionsstrahls (PB) einer Strahlung;
    - eine Lagerstruktur (MT) zum Lagern von Musterungsmitteln, wobei die Musterungsmittel (MA) dazu dienen, den Projektionsstrahl gemäß einem gewünschten Muster zu mustern;
    - einen Substrattisch (WT) zum Halten eines Substrats (W); und
    - ein Projektionssystem (PL) zur Projektion des gemusterten Strahls auf einen Zielabschnitt (C) des Substrats;

wobei die Vorrichtung weiterhin aufweist:

    - Mittel, die eine direkte Bestimmung in Echtzeit wenigstens eines Parameters eines im Raum erzeugten Bildes, gebildet durch das Projektionssystem (PL) eines Testmusters (200) durchzuführen vermögen, mit einem zweidimensionalen Gitter (207) von isolierten Bereichen (310, 320, 330, 340, 350, 360), wobei die Einzelzelle (209) des Gitters wenigstens drei der isolierten Bereiche aufweist, **dadurch gekennzeichnet, dass**:

    der Parameter (523, 633) eine Differenz zwischen den Bildern (450, 460) der beiden isolierten Bereiche (330, 360) innerhalb einer Einzelzelle (209) darstellt.

## Revendications

1. Procédé pour déterminer l'aberration d'un système de projection d'un appareil lithographique, comportant :

   - un système de rayonnement (IL) pour délivrer un faisceau de projection de rayonnement ;
   - une structure de support (MT) pour supporter des moyens de mise en forme (MA), les moyens de mise en forme servant à mettre en forme le faisceau de projection conformément à un motif voulu ;
   - une table de substrat (WT) pour tenir un substrat ; et
   - un système de projection (PL) pour projeter le faisceau mis en forme sur une partie cible du substrat ; le procédé comportant les étapes consistant à :

       - mettre en forme le faisceau de projection à l'aide desdits moyens de mise en forme conformément à un motif test (200) ;
       - effectuer une détermination directe en temps réel d'au moins un paramètre d'une image aérienne du motif test, formé par le système de projection ; et
       - calculer au moins un coefficient, représentatif de l'aberration dudit système de projection, sur la base dudit au moins un paramètre ;

   dans lequel ledit motif test (200) comporte un réseau bidimensionnel (207) de zones isolées qui contrastent avec une zone dudit motif test comportant lesdites zones isolées, et la cellule unitaire (209) dudit réseau comporte au moins trois desdites zones isolées ;
   **caractérisé en ce que** ledit paramètre (523, 633) représente une différence entre les images (450, 460) de deux des zones isolées (350, 360) dans une même cellule unitaire.

2. Procédé selon la revendication 1, dans lequel ladite cellule unitaire (209) dudit réseau est une cellule hexagonale comportant six zones isolées (310-360) positionnées aux ou à proximité des six coins de la cellule hexagonale.

3. Procédé selon la revendication 1, dans lequel ladite cellule unitaire (209) dudit réseau (207) a une forme sélectionnée parmi le groupe de formes comportant une forme triangulaire, une forme quadrangulaire et une forme hexagonale.

4. Procédé selon la revendication 1, dans lequel ladite différence est une différence dans une propriété sélectionnée parmi le groupe de propriétés constitué d'intensité de pic, intensité intégrée spatialement, distribution d'intensité spatiale, la forme d'une section transversale d'image et la taille d'une section transversale d'image.

5. Procédé selon l'une quelconque des revendications 1 à 4, dans lequel lesdites au moins deux des zones isolées au sein d'une cellule unitaire sont des zones voisines (350, 360) au sein d'une même cellule unitaire.

6. Procédé selon l'une quelconque des revendications 1 à 5 dans lequel ladite détermination directe en temps réel est effectuée à l'aide de moyens de détection de rayonnement comportant une pluralité d'ouvertures de rayonnement, déployées selon un motif matriciel bidimensionnel.

7. Procédé selon l'une quelconque des revendications 1 à 6 dans lequel ladite détermination directe en temps réel est effectuée pour une pluralité de réglages différents d'au moins un système sélectionné parmi le groupe de systèmes constitué dudit système de rayonnement (IL) et dudit système de projection (PL).

8. Procédé selon la revendication 7, dans lequel ladite pluralité de réglages différents comporte différents réglages d'ouverture numérique.

9. Procédé selon la revendication 7 ou 8, dans lequel ladite pluralité de réglages différents comporte des réglages différents de l'étendue radiale extérieure et/ou intérieure de la distribution d'intensité à un plan de pupille dans le système de rayonnement.

10. Procédé selon la revendication 7, 8 ou 9, dans lequel ladite pluralité de réglages différents comporte des modes d'éclairage différents sélectionnés parmi le groupe comportant un mode d'éclairage discoïdal, annulaire, quadripolaire, dipolaire et multipolaire doux.

**11.** Procédé selon l'une quelconque des revendications précédentes, dans lequel ledit au moins un paramètre est la position de meilleure mise au point et/ou la position latérale de ladite image du motif test.

**12.** Procédé selon l'une quelconque des revendications précédentes, comportant de plus l'étape de calcul d'une variation théorique, pour chacun de ladite pluralité de réglages différents, du ou de chaque paramètre déterminé en fonction d'un changement dudit au moins un coefficient.

**13.** Procédé selon l'une quelconque des revendications précédentes, dans lequel ledit au moins un coefficient est calculé par régression multiple ou par un ajustement par moindres carrés d'un ensemble d'équations simultanées.

**14.** Procédé selon l'une quelconque des revendications précédentes, dans lequel ledit au moins un coefficient est un coefficient de Zernike.

**15.** Procédé selon l'une quelconque des revendications précédentes, dans lequel ledit motif test comporte au moins un motif test supplémentaire pour déterminer des aberrations.

**16.** Procédé selon la revendication 15, dans lequel ledit au moins un motif test supplémentaire est sélectionné parmi le groupe de structures de motif bidimensionnel comportant un segment d'un réseau ayant des lignes et des espaces périodiques, et d'une structure répétitive de zones isolées parallèles en forme de ligne.

**17.** Procédé pour fabriquer un dispositif en utilisant un appareil de projection lithographique, comportant les étapes consistant à :

- fournir un substrat (W) qui est au moins partiellement recouvert d'une couche de matériau sensible au rayonnement ;
- fournir un faisceau de projection (PB) de rayonnement en utilisant un système de rayonnement ;
- utiliser des moyens de mise en forme (MA) pour doter le faisceau de projection d'un motif dans sa section transversale ;
- utiliser un système de projection (PL) pour projeter le faisceau de rayonnement mis en forme sur une partie cible de la couche de matériau sensible au rayonnement ; et

avant l'étape d'utilisation du système de projection, déterminer l'aberration dudit système de projection par un procédé selon l'une quelconque des revendications précédentes et

corriger ladite aberration sur la base dudit au moins un coefficient calculé, pour réduire l'aberration d'une image projetée par ledit système de projection.

**18.** Appareil lithographique comportant :

- un système de rayonnement (IL) pour délivrer un faisceau de projection (PB) de rayonnement ;
- une structure de support (MT) pour supporter des moyens de mise en forme, les moyens de mise en forme (MA) servant à mettre en forme le faisceau de projection conformément à un motif voulu ;
- une table de substrat (WT) pour tenir un substrat (W) ; et
- un système de projection (PL) pour projeter le faisceau mis en forme dans une partie cible (C) du substrat ;

dans lequel ledit appareil comporte de plus

- des moyens agencés pour effectuer une détermination directe en temps réel d'au moins un paramètre d'une image aérienne formée par le système de projection (PL) d'un motif test (200) comportant un réseau bidimensionnel (207) de zones isolées (310, 320, 330, 340, 350, 360), dans lequel la cellule unitaire (209) dudit réseau comporte au moins trois desdites zones isolées; **caractérisé en ce que** :

ledit paramètre (523, 633) représente une différence entre les images (450, 460) de deux des zones isolées (350, 360) au sein d'une même cellule unitaire (209).

# Fig.1.

# Fig.2.

# Fig.3.

# Fig.4.

# Fig.5.

# Fig.6.

Fig.7.

| 1 | 2 | 3 | 4 | 5 |
|---|---|---|---|---|
| Z5 | $r^2 \cos 2\theta$ | third order | x astigmatism | hc x,y |
| Z6 | $r^2 \sin 2\theta$ | third order | 45° astigmatism | |
| Z7 | $(3r^3 - 2r)\cos\theta$ | third order | x coma | hc x |
| Z8 | $(3r^3 - 2r)\sin\theta$ | third order | y coma | hc y |
| Z9 | $6r^4 - 6r^2 + 1$ | third order | spherical aberration | hc x,y |
| Z10 | $r^3 \cos 3\theta$ | fifth order | x three-wave aberration | hc x |
| Z11 | $r^3 \sin 3\theta$ | fifth order | y three-wave aberration | hc y |
| Z12 | $(4r^4 - 3r^2)\cos 2\theta$ | fifth oredr | x astigmatism | hc x,y |
| Z13 | $(4r^4 - 3r^2)\sin 2\theta$ | fifth order | 45° astigmatism | |
| Z14 | $(10r^5 - 12r^3 + 3r)\cos\theta$ | fifth order | x coma | hc x |
| Z15 | $(10r^5 - 12r^3 + 3r)\sin\theta$ | fifth order | y coma | hc y |
| Z16 | $20r^6 - 30r^4 + 12r^2 - 1$ | fifth order | spherical aberration | hc x,y |
| Z17 | $r^4 \cos 4\theta$ | seventh order | x four-wave aberration | hc x |
| Z18 | $r^4 \sin 4\theta$ | seventh order | y four-wave aberration | hc y |
| Z19 | $(5r^5 - 4r^3)\cos 3\theta$ | seventh order | x three-wave aberration | hc x |
| Z20 | $(5r^5 - 4r^3)\sin 3\theta$ | seventh order | y three-wave aberration | hc y |
| Z21 | $(15r^6 - 20r^4 + 6r^2)\cos 2\theta$ | seventh order | x astigmatism | hc x,y |
| Z22 | $(15r^6 - 20r^4 + 6r^2)\sin 2\theta$ | seventh order | 45° astigmatism | |
| Z23 | $(35r^7 - 60r^5 + 30r^3 - 4r)\cos\theta$ | seventh order | x coma | hc x |
| Z24 | $(35r^7 - 60r^5 + 30r^3 - 4r)\sin\theta$ | seventh order | y coma | hc y |
| Z25 | $70r^8 - 140r^6 + 90r^4 - 20r^2 + 1$ | seventh order | spherical aberration | hc x,y |

EP 1 286 223 B1

# Fig.8.

# Fig.9.